Europäisches Patentamt

European Patent Office

Office européen des brevets

(11) Veröffentlichungsnummer: **0 242 574 B1**

# EUROPÄISCHE PATENTSCHRIFT

(45) Veröffentlichungstag der Patentschrift: **24.07.91**

(21) Anmeldenummer: **87103592.9**

(22) Anmeldetag: **12.03.87**

(51) Int. Cl.⁵: **G03F 7/20**, G01J 3/20, G02B 5/18, G02B 6/34

(54) Verfahren zum Herstellen eines passiven optischen Bauelements mit einem oder mehreren Echelette-Gittern und nach diesem Verfahren hergestelltes Bauelement.

(30) Priorität: **04.04.86 DE 3611246**

(43) Veröffentlichungstag der Anmeldung:
**28.10.87 Patentblatt 87/44**

(45) Bekanntmachung des Hinweises auf die
Patenterteilung:
**24.07.91 Patentblatt 91/30**

(84) Benannte Vertragsstaaten:
**CH DE FR GB IT LI NL SE**

(56) Entgegenhaltungen:
**EP-A- 0 020 132
EP-A- 0 073 300
EP-A- 0 121 812**

**KERNFORSCHUNGSZENTRUM KARLSRUHE,
INSTITUT FÜR KERN VERFAHRENSTECHNIK,
KfK 3995, November 1985, ISSN 0303-4003; E.
BECKER et al.: "Herstellung von Mikrostrukturen mit grossem Aspektverhältnis und
grosser Strukturhöhe durch Röntgentiefenlithographie mit Synchrotronstrahlung, Galvanoformung und Kunststoffabformung
(LIGA-Verfahren)"**

(73) Patentinhaber: **KERNFORSCHUNGSZENTRUM
KARLSRUHE GMBH
Weberstrasse 5 Postfach 3640
W-7500 Karlsruhe 1(DE)**

(72) Erfinder: **Ehrfeld, Wolfgang, Dr.
Reutstrasse 27
W-7500 Karlsruhe 41(DE)**
Erfinder: **Münchmeyer, Dietrich, Dr.
Hagäckerstrasse 5
W-7513 Stutensee 3(DE)**

PATENT ABSTRACTS OF JAPAN, Band 7, Nr. 51 (P-179)[1196], 26. Februar 1983; & JP-A-57 198 423 (NIHON ITA GLASS K.K.) 06-12-1982

PATENT ABSTRACTS OF JAPAN, Band 8, Nr. 133 (P-281)[1570], 20. Juni 1984; & JP-A-59 36 222 (NIPPON DENKI K.K.) 28-02-1984

JOURNAL OF VACUUM SCIENCE TECHNOLOGY, Band 16, Nr. 6, November/Dezember 1979, Seiten 1615-1619, American Vacuum Society, New York, US; D.C. FLANDERS: "X-ray lithography at - 100 A linewidths using x-ray masks fabricated by shadowing techniques"

## Beschreibung

Die Erfindung betrifft ein Verfahren zum Herstellen eines passiven optischen Bauelements mit einem oder mehreren Echelette-Gittern sowie wenigstens einem Anschluß für polychromatisches Licht und mehreren Anschlüssen für monochromatisches Licht sowie nach diesem Verfahren hergestellte Bauelemente.

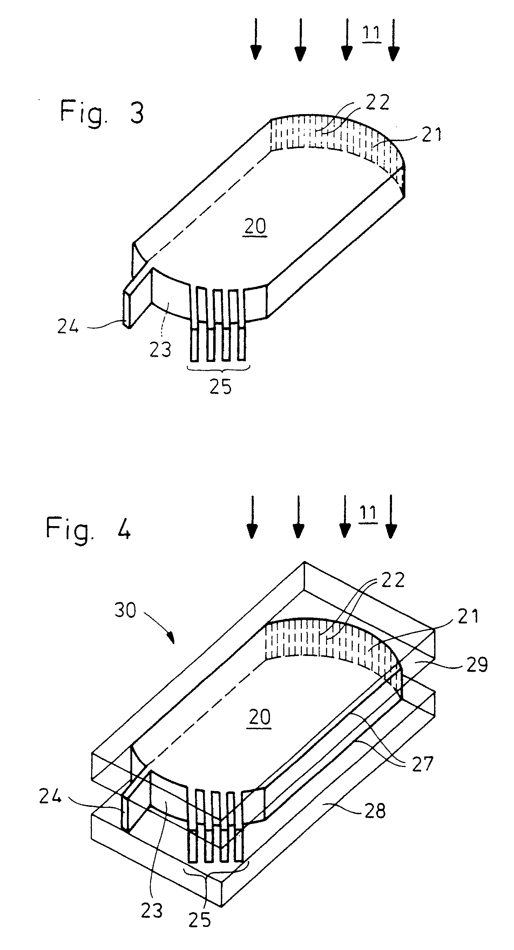

Ein derartiges Bauelement mit einem ebenen Echelette-Gitter ist in SPJE, Vol, 503, Application, Theory and Fabrication of Periodic Structures (1984), Seiten 22 bis 28, in einem Beitrag von J-P.Lande und J.M.Lerner dargestellt und beschrieben. Die Figur 4a auf Seite 24 zeigt eine Stimax-Anordnung mit einem konkaven Spiegel zur Fokussierung. Eine Reihe von Lichtleiterfasern ist vor einem photolithographisch hergestellten Spalt in der Mitte eines ebenen Reflexionsgitters (Echelette-Gitter) angeordnet. Der divergente Strahl aus einer der Eingangsfasern wird von dem konkaven Spiegel als paralleler Strahl auf das Echelette-Gitter reflektiert. Das Gitter sendet das Licht winkeldispergiert auf den Spiegel zurück. Der Spiegel fokussiert sodann das spektral aufgeteilte Bild der Eingangsfaser auf die Ausgangsfasern, die in der Mitte des Gitters angeordnet sind.

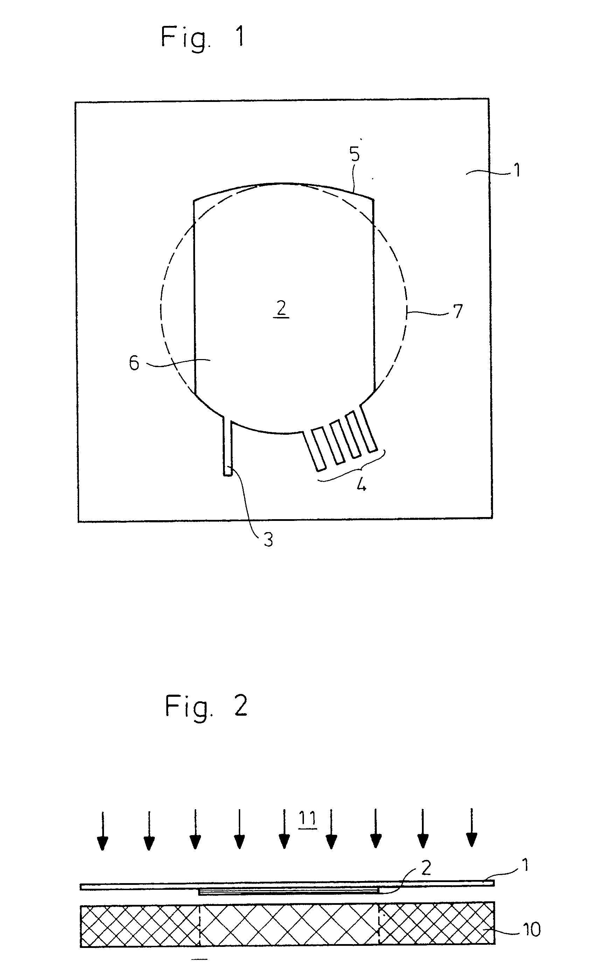

In Optics Letters, Vol. 6, No. 12, December 1981, Seiten 639 bis 641 ist in einem Beitrag von H.W. Yen et al. ein Rowland-Spektrometer für glasfaseroptisches Wellenlängen-Demultiplexen beschrieben. In der Figur 1 auf Seite 639 ist schematisch ein flaches Rowland-Spektrometer dargestellt, bestehend aus einem flachen, beidseitig abgedeckten Wellenleiter mit zwei einander gegenüberliegenden, gekrümmten Stirnflächen. An der einen Stirnfläche sind Glasfasern angeschlossen, auf der anderen Stirnfläche ist ein nachgiebiges Echelette-Gitter aufgepreßt.

Beide Bauelement erfüllen die Funktion eines Wellenlängen-Demultiplexers bzw. -Multiplexers in optischen Nachrichtenübertragungssystemen.

Die Herstellung dieser Bauelement ist technisch relativ aufwendig, da die Komponenten, insbesondere die Echelette-Gitter, in getrennten Fertigungsverfahren hergestellt und sodann sehr sorgfältig justiert und montiert werden müssen.

Der Erfindung liegt die Aufgabe zugrunde, ein passives optisches Bauelement der gattungsgemäßen Art herzustellen, bei dem die Fertigung der Komponenten in gemeinsamen Arbeitsgängen unter Wegfall einer gesonderten Justierung ermöglicht wird.

Diese Aufgabe wird mit den im Kennzeichen von Patentanspruch 1 enthaltenen Merkmalen gelöst. Die hierauf bezogenen Unteransprüche beinhalten nach diesem Verfahren hergestellte charakteristische Bauelemente.

Bei der Röntgentiefenlithographie werden Röntgenmasken benutzt, bei denen die Querschnitte der optischen Komponenten wie Echelette-Gitter, Spiegel, Zylinderlinsen, Lichtleiter in Form von Absorberstrukturen bezüglich ihrer geometrischen Gestalt und ihrer gegenseitigen Zuordnung mit extrem hoher Genauigkeit vorgebbar und mit Hilfe der Röntgenstrahlung auf das herzustellende Produkt übertragbar sind. Bei den auf die Röntgenbestrahlung nachfolgenden gemeinsamen Arbeitsgängen bleibt diese Genauigkeit so weitgehend erhalten, daß keine Nachbearbeitungen, insbesondere keine Justierarbeiten, mehr erforderlich sind.

Die erfindungsgemäßen Bauelemente können außer in optischen Nachrichtenübertragungssystemen auch in wellenlängenselektiven Detektoren für meßtechnische Zwecke eingesetzt werden.

Ausführungsbeispiele der Erfindung werden im folgenden anhand der Zeichnungen erläutert:

Die Figuren 1 bis 3 veranschaulichen die Herstellung der optischen Komponenten eines Bauelementes auf röntgentiefenlithographischem Wege;

die Figur 4 zeigt das fertig montierte, passive optische Bauelement als Rowland-Anordnung;

die Figur 5 zeigt eine Variante einer Rowland-Anordnung gemäß Figur 4, bei der die optischen Komponenten ebenfalls aus einem röntgenstrahlenempfindlichen, transparenten Kunststoff bestehen;

die Figuren 6 und 7 veranschaulichen die Herstellung der optischen Komponenten eines Bauelementes auf röntgentiefenlithographisch-galvanoplastischem Wege;

die Figur 8 zeigt die auf einer Grundplatte aufgebauten metallischen Komponenten einer Rowland-Anordnung, ebenfalls mit gekrümmtem Echelette-Gitter wie bei Figuren 4 und 5;

die Figur 9 zeigt eine Stimex-Anordnung;

die Figur 10 zeigt eine Anordnung mit Zylinderlinse, die auf abformtechnischem Wege hergestellt wurden;

die Figur 11 zeigt ein Echelette-Gitter mit variablen Stufenwinkeln und Gitterlinien.

Figur 1 zeigt in der Draufsicht eine Röntgenmaske 1 mit Absorberstrukturen 2, die die Form eines Lichtleiteranschlusses 3 für polychromatisches Licht, von Lichtleiteranschlüssen 4 für monochromatisches Licht, eines gekrümmten Echelette-Gitters 5 sowie eines diese Strukturen 3 bis 5 verbindenden lichtleitenden Körpers 6 aufweisen. Die Komponenten 3 bis 5 sind entsprechend einer Rowland-Anordnung positioniert, d.h. die Lichtleiteranschlüsse 3 und 4 enden auf einem Kreis 7; der Krümmungsradius des Echelette-Gitters 5 beträgt das Doppelte des Radius des Kreises 7 und berührt diesen. Die Erzeugung der Absorberstrukturen 2 erfolgt mit Hilfe der Elektronenstrahllithographie (vgl. z.B. DE-PS 35 29 966) mit extrem hoher Genauigkeit. In der Regel trägt eine Röntgenmaske parallel eine größere Anzahl derartiger Absorberstrukturen.

Figur 2 zeigt im Querschnitt die Übertragung der Absorberstrukturen 2 der Maske 1 in eine Schicht 10 aus Polymethylmethacrylat PMMA durch Röntgentiefenlithographie mit Synchrotronstrahlung 11, wie in dem KfK-Bericht 3995 des Kernforschungszentrums Karlsruhe (November 1985) ausführlich beschrieben und dargestellt. Nach dem Entwickeln des PMMA entsteht der in Figur 3 perspektivisch dargestellte plattenförmige, lichtdurchlässige Körper 20, dessen eine Stirnseite als gekrümmtes Echelette-Gitter 21 ausgebildet ist, dessen Krümmung senkrecht und dessen Gitterlinien 22 parallel zur Röntgenstrahlung 11 verlaufen. Auf der gegenüberliegenden Stirnseite 23 befindet sich ein Lichtleiteranschluß 24 für polychromatisches Licht und mehrere Lichtleiteranschlüsse 25 für monochromatisches Licht. Das Echelette-Gitter 21 wird durch Aufdampfen von Silber außen verspiegelt.

Wie in Figur 4 dargestellt, wird der Körper 20 mit den optischen Komponenten 21 bis 25 mit einem Epoxidharzkleber 27 zwischen zwei Glasplatten 28, 29 geklebt, wodurch das passive optische Bauelement 30 fertiggestellt wird. Die genauen Abmessungen und Positionen der optischen Komponenten sind entsprechend dem Anwendungsproblem für das Bauelement zu wählen. Für die Anwendung als Demultiplexer in einem optischen Nachrichtenübertragungssystem mit Wellenlängen-Multiplexbetrieb im Wellenlängenbereich von etwa 1,0 bis 1,6 µm ist beispielsweise ein Radius des Rowlandkreises 7 von etwa 5 mm bei einem Abstand der Gitterlinien 22 des Echelette-Gitters 21 von 2 bis 3 µm und einer Dicke der PMMA-Schicht 10 bzw. des Körpers 20 von 50 - 100 µm vorteilhaft.

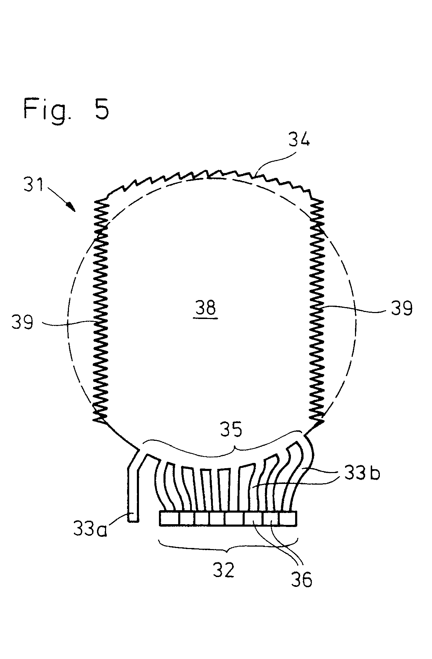

Figur 5 zeigt in der Draufsicht ein entsprechendes passives optisches Bauelement 31 für den Einsatz als kompaktes optisches Spektrometer in Verbindung mit einem Diodenarray 32 als wellenlängenselektiver Sensor. Das über einen Lichtleiter 33a einfallende polychromatische Licht wird mittels des Echelette-Gitters 34 zerlegt und gelangt über speziell geformte Lichtleiter 33b, die das gekrümmte Bildfeld 35 an das ebene Diodenarray 32 anpassen, auf die Einzelelemente 36 des Diodenarrays 32. Der lichtleitende Körper 38 wird an den seitlichen Stirnflächen durch simultan mit dem Echelette-Gitter 34 hergestellte Antireflexstrukturen 39 begrenzt.

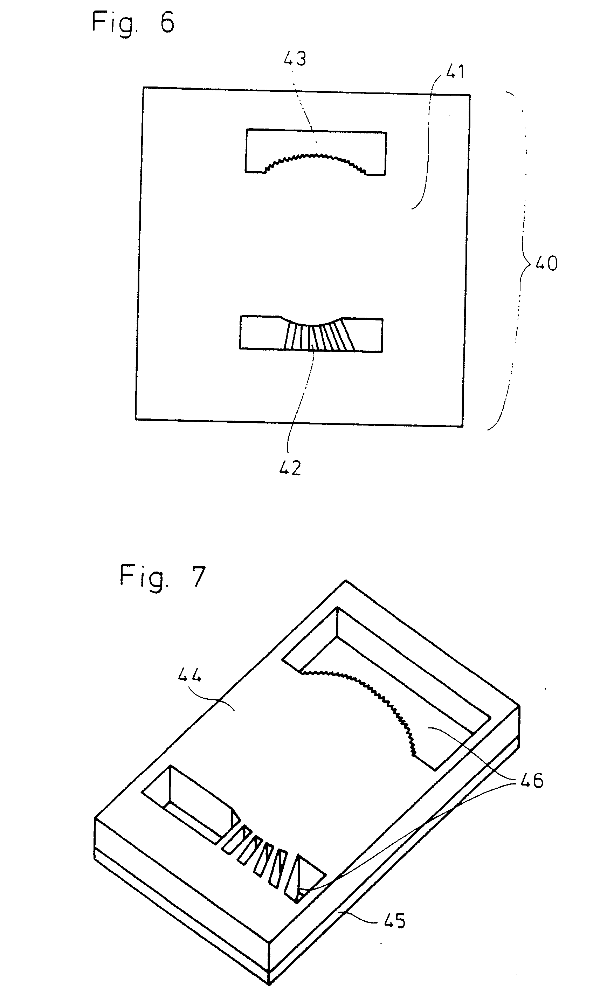

Die Figuren 6 bis 8 zeigen die Herstellung eines metallischen passiven optischen Bauelements nach dem röntgentiefenlithographisch-galvanoplastischen Verfahren.

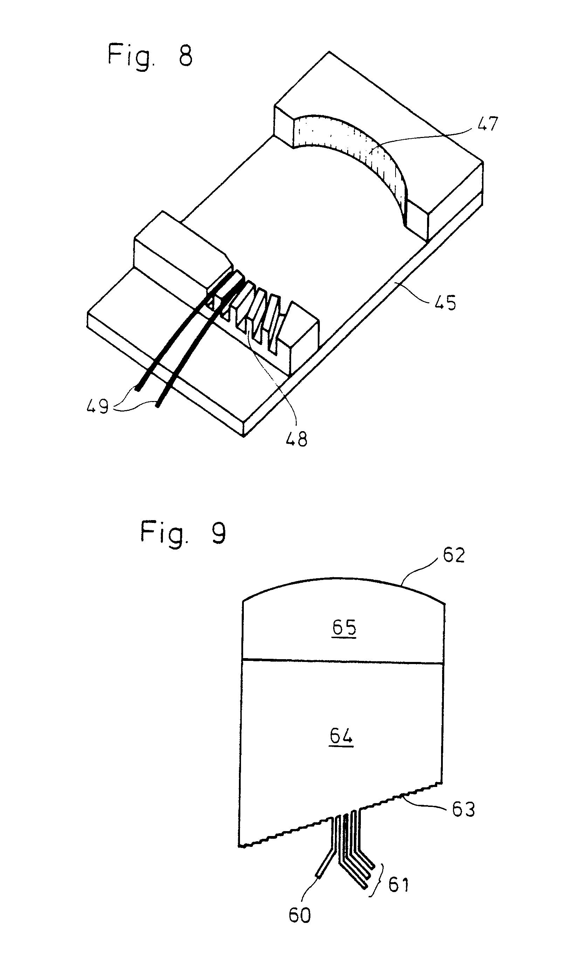

Figur 6 zeigt in der Draufsicht eine Röntgenmaske 40 mit Absorberstrukturen 41 in der Form von Halteelementen 42 als Lichtleiteranschlüsse für polychromatisches und monochromatisches Licht sowie eines gekrümmten Echelette-Gitters 43 in Rowland-Anordnung. Durch Röntgentiefenlithogrphie mit Synchrotronstrahlung wird mit dieser Maske 40 die in Figur 7 dargestellte PMMA-Form 44 hergestellt, die sich auf einer metallischen Grundplatte 45 befindet. In diese Form wird galvanisch Nickel 46 abgeschieden. Nach dem Herauslösen des PMMA entsteht das in Figur 8 dargestellte metallische, passive optische Bauelement, bestehend aus einer Grundplatte 45, einem gekrümmten, metallischen Echelette-Gitter 47 und Halteelemente 48 für Glasfasern 49 als Lichtanschlüsse. Die typischen Abmessungen für die Optik sind ähnlich wie die des Bauelementes in Figur 4; lediglich die Dicke der Strukturen 47, 48 wird zweckmäßig einige 100 µm groß gewählt.

Die Figuren 9 bis 11 zeigen schematisch in der Draufsicht Beispiele für andere Anordnungen der optischen Komponenten für erfindungsgemäße passive Bauelemente.

Figur 9 zeigt eine Stimax-Anordnung mit Korrektur der sphärischen Aberration durch Unterteilung des lichtleitenden Bereichs in zwei Unterbereiche 64, 65 mit unterschiedlichen Brechungsindices. Die Stirnseite des Unterbereichs 64 weist ein ebenes Echelette-Gitter 63 und Anschlüsse 60, 61 für polychromatisches und monochromatisches Licht in der Mitte des Echelette-Gitters auf. Die Stirnseite des Unterbereichs 65 ist als Hohlspiegel 62 ausgebildet. Die Herstellung solcher Bauelemente erfolgt auf abformtechnischem Wege mit zwei verschiedenen transparenten Kunststoffen. Dabei werden auf röntgentiefenlithographisch-galvanoplastischem Wege hergestellte Mutterwerkzeuge, deren Strukturen die Negative der optischen Komponenten 64, 65 aufweisen, mit für diese optischen Zwecke geeigneten Kunststoffen abgeformt.

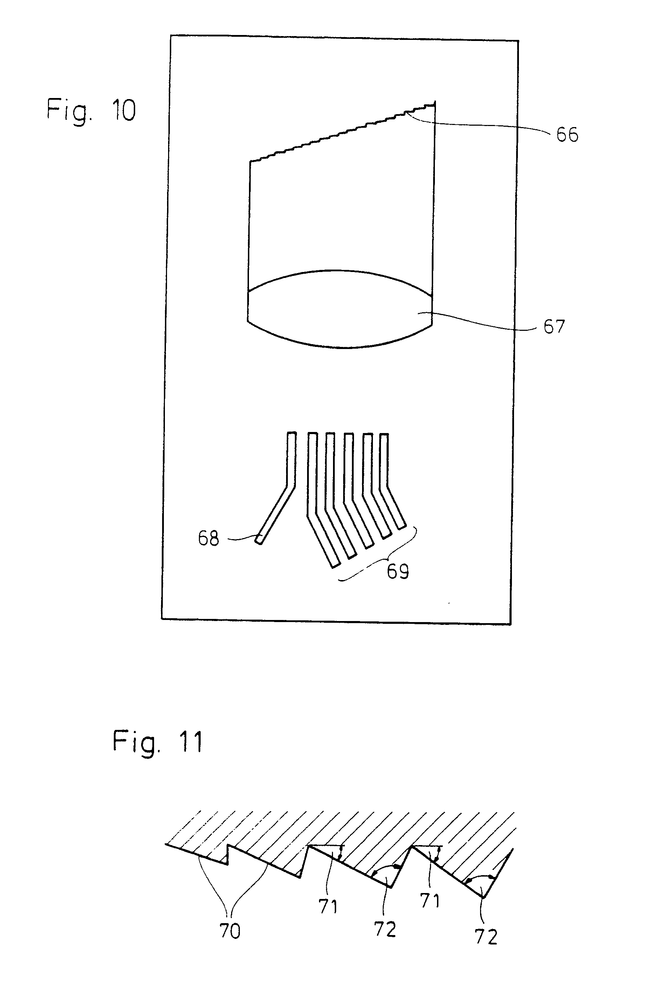

Figur 10 zeigt eine ähnliche Anordnung mit einem ebenen Echelette-Gitter 66, einer Zylinderlinse 67 und den Anschlüssen 68, 69 für das polychromatische bzw. monochromatische Licht auf. Auch in diesem Falle bestehen das Bauteil mit dem Echelette-Gitter 66 und die Zylinderlinse 67 aus mit Mutterwerkzeugen abgeformten, transparenten Kunststoffen unterschiedlicher Brechungsindices. Die Zylinderlinse 67 ist zwischen den Anschlüssen 68, 69 und dem Echelette-Gitter 66 angeordnet, wobei die Oberflächen der Zylinderlinse in einer senkrecht zur Röntgenstrahlung liegenden Ebene gekrümmt sind, bezogen auf die Richtung der Röntgenstrahlung für die Herstellung des Mutterwerkzeugs.

Figur 11 zeigt, daß mit den erfindungsgemäßen Methoden neben den gezeigten Anordnungen mit ebenen oder zylindrisch gekrümmten Echelette-Gittern mit streng periodischen Gitterlinien auch Anordnungen leicht realisierbar sind, bei denen durch beliebige Krümmungen des Echelette-Gitters mit parallel zur Röntgenstrahlung verlaufenden Gitterlinien 70, durch Abweichungen von der strengen Periodizität der Gitterlinien 70 und durch freie Variation der Stufenwinkel 71, 72 optische Fehler höherer Ordnung korrigiert oder besondere Anforderungen, etwa bezüglich der Ebenheit des Bildfeldes, erfüllt werden können. Auch diese Ausführungsform des Echelette-Gitters läßt sich gemeinsam mit den anderen optischen Komponenten wie den Anschlüssen für die Lichtleiter herstellen.

**Patentansprüche**

1. Verfahren zum Herstellen eines passiven optischen Bauelements mit einem oder mehreren Echelette-Gittern sowie wenigstens einem Anschluß für polychromatisches Licht und mehreren Anschlüssen für monochromatisches Licht, dadurch gekennzeichnet,
daß die optischen Komponenten (20 bis 25) des Bauelements (30) einschließlich des oder der Echelette-Gitter (21) auf röntgentiefenlithographischem Wege hergestellt werden, wobei das röntgentiefenlithographische Verfahren so durchgeführt wird, daß die Gitterlinien (22) des Echelette-Gitters (21) in eine Richtung parallel zur Röntgenstrahlung entstehen.

2. Verfahren nach Anspruch 1, dadurch gekennzeichnet,
daß auf röntgentiefenlithographisch-galvanoplastischem Wege ein Mutterwerkzeug hergestellt wird, dessen Strukturen die Negative der optischen Komponenten (64, 65) aufweisen, und daß das Mutterwerkzeug mit einem transparenten Kunststoff abgeformt wird.

3. Verfahren nach Anspruch 1 oder 2, dadurch gekennzeichnet,
daß wenigstens ein Teil der Anschlüsse (24, 25) in Form von Lichtleitern zusammen mit den anderen optischen Komponenten (20, 21) hergestellt wird.

**Claims**

1. Method of manufacturing a passive, optical, constructional element with one or more echelette gratings and at least one connection for polychromatic light and a plurality of connections for monochromatic light, characterised in that the optical components (20 to 25) of the constructional element (30), including the echelette grating or gratings (21), are manufactured by an X-ray deep-lithographic process, the X-ray deep-lithographic process being so effected that the grating lines (22) of the echelette grating (21) extend in a direction parallel with the X-radiation.

2. Method according to claim 1, characterised in that a mother tool is manufactured by an X-ray deep-lithographic-galvanoplastic process, the structures of said tool being the negatives of the optical components (64, 65), and in that the mother tool is formed from a transparent plastics material.

3. Method according to claim 1 or 2, characterised in that at least some of the connections (24, 25) are manufactured in the form of photoconductors together with the other optical components (20, 21).

**Revendications**

1. Procédé pour la fabrication d'un élément optique passif avec un ou plusieurs réseaux-échelette, ainsi qu'au moins un raccordement pour lumière polychromatique et plusieurs raccordements pour lumière monochromatique, caractérisé en ce que les composants optiques (20 à 25) de l'élément (30), y compris le ou les réseaux-échelette (21) sont fabriqués par des moyens de lithographie Röntgen en profondeur, le procédé lithographique en profondeur Röntgen étant effectué de façon que les lignes (22) du réseau-échelette (21) soient créées en direction parallèlement au rayonnement Röntgen.

2. Procédé selon la revendication 1, caractérisé en ce que par les moyens galvanoplastiques de lithographie en profondeur Röntgen, on produit un outil-mère, dont les structures représentent les négatifs des composants optiques (64, 65) et en ce que l'outil-mère est moulé en une matière plastique transparente.

3. Procédé selon une des revendications 1 ou 2, caractérisé en ce qu'au moins une partie des raccordements (24, 25) en forme des fibres optiques est produite ensemble avec les autres composants optiques (20, 21).

Fig. 1

Fig. 2

Fig. 3

Fig. 4

Fig. 5

Fig. 6

Fig. 7

Fig. 8

47

45

49

48

Fig. 9

62

65

64

63

61

60

Fig. 10

66

67

68

69

Fig. 11

70

71

72

71

72